# EUROPÄISCHE PATENTSCHRIFT

(11) **EP 0 731 362 B1**
(45) Veröffentlichungstag und Bekanntmachung des Hinweises auf die Patenterteilung: **14.07.1999**
(21) Anmeldenummer: 96200469.3
(22) Anmeldetag: 23.02.1996
(51) Int. Cl.: G01R 33/563, A61B 5/055

(54) **MR-Verfahren und MR-Gerät zur Durchführung des Verfahrens**
MR method and apparatus for carrying out the method
Procédé RM et dispositif pour sa mise en oeuvre

(30) Priorität: 04.03.1995 DE 19507617
(43) Veröffentlichungstag der Anmeldung: 11.09.1996
(73) Patentinhaber: Philips Patentverwaltung GmbH, 22335 Hamburg (DE); Koninklijke Philips Electronics N.V., 5621 BA Eindhoven (NL)
(72) Erfinder: Rasche, Volker, D-22335 Hamburg (DE); Röschmann, Peter, D-22335 Hamburg (DE)
(74) Vertreter: Hartmann, Heinrich, Dipl.-Ing.

(56) Entgegenhaltungen:
- US-A- 5 307 808

## Beschreibung

Die Erfindung betrifft ein Magnetresonanz-Verfahren - im folgenden auch als MR-Verfahren bezeichnet - zur Bestimmung der Kernmagnetisierungs-Verteilung in einem Untersuchungsbereich und zur Bestimmung der Position wenigstens einer Mikrospule, gemäß dem Oberbegriff des Anspruchs 1. Außerdem betrifft die Erfindung ein Magnetresonanz-Gerät zur Durchführung dieses Verfahrens.

Als Mikrospule wird dabei und im folgenden eine Spule bezeichnet, die MR-Signale lediglich aus einem Bereich aufnehmen kann, der klein ist im Vergleich zum gesamten Untersuchungsbereich. Als Gradientenrichtung wird die Richtung bezeichnet, in der der Gradient des magnetischen Gradientenfeldes verläuft. MR steht für magnetische Resonanz.

Ein MR-Verfahren der eingangs genannten Art ist aus der US-PS 5 318 025 bekannt. Dabei sind eine bzw. mehrere Mikrospulen mit einem in den Körper eines Patienten eingeführten Instrument z. B. einem Katheter verbunden. Die Position der Mikrospule wird dabei durch drei aufeinanderfolgende Sequenzen bestimmt, die einen Hochfrequenzimpuls umfassen, wonach ein MR-Signal unter dem Einfluß eines magnetischen Gradientenfeldes empfangen wird. Die Gradientenrichtungen bei diesen drei Sequenzen entsprechen dabei der x-, der y- und der z-Richtung. Das Spektrum des MR-Signals, das der Fourier-Transformation des MR-Signals entspricht, hat in der Gradientenrichtung ein Maximum an der Stelle im Untersuchungsbereich, von der die Mikrospule ein MR-Signal aufnehmen kann. Somit läßt sich die Position der Mikrospule durch Bestimmung der Maxima in den drei Gradientenrichtungen ermitteln.

Die Positionsbestimmung kann durch Wiederholungen fortgeführt werden, solange dies erwünscht ist. Anderenfalls werden mit einer zusätzlichen Empfangsspulen-Anordnung die MR-Daten ermittelt, aus denen sich die Kernmagnetisierungsverteilung im Untersuchungsbereich, d.h. ein MR-Bild ableiten läßt. Die Ermittlung der MR-Positionsdaten und der MR-Bilddaten kann auch abwechselnd erfolgen. Die Positionsdaten können dabei in das erzeugte MR-Bild eingeblendet werden, so daß ein Untersucher die Position des Instruments (Katheter) fortlaufend bestimmen und im MR-Bild erkennen kann.

Von Nachteil ist dabei, daß die Bilddaten und die Positionsdaten aus MR-Signalen abgeleitet werden müssen, die zu unterschiedlichen Zeitpunkten detektiert wurden. Bei der Darstellung der Position der Mikrospule im MR-Bild können sich daher Fehler ergeben, wenn sich die Anatomie des Patienten beispielsweise durch Bewegung oder einen chirurgischen Eingriff ändert. Weiterhin ist von Nachteil, daß die zur Positionsbestimmung erforderlichen Sequenzen zusätzlich zu den zur Bildgebung erforderlichen Sequenzen erzeugt werden müssen, wodurch die Belastung für den Patienten erhöht wird.

Aufgabe der vorliegenden Erfindung ist es, ein Verfahren der eingangs genannten Art so auszugestalten, daß die geschilderten Fehler bei einer Änderung der Anatomie weitgehend unterbleiben und die HF-Belastung für den Patienten verringert wird.

Diese Aufgabe wird erfindungsgemäß durch die im Anspruch 1 angegebenen Maßnahmen gelöst.

Wesentlich für die Erfindung ist, daß auch bei der Erfassung der MR-Signale, aus denen das MR-Bild des Untersuchungsbereichs abgeleitet wird, die Gradientenrichtung von Sequenz zu Sequenz geändert wird. Das heißt, die MR-Bilddaten werden nach der sogenannten Projektions-Rekonstruktionsmethode akquiriert, die z.B. aus der DE-OS 43 19 539 bekannt ist und bei der zwischen dem bzw. den Hochfrequenzimpuls(en) und der Erfassung des MR-Signals keine Phasencodierung durch ein während dieses Zeitintervalls wirksames Gradientenfeld erfolgt. Deshalb läßt sich aus aufeinanderfolgenden MR-Signalen, die die Mikrospule detektiert, während die Empfangsspulen-Anordnung die MR-Signale für das MR-Bild empfängt, fortlaufend die Position der MR-Spule bestimmen, ohne daß die Zahl der Sequenzen erhöht werden muß. Die MR-Daten für das MR-Bild und für die Positionsbestimmung werden dabei gleichzeitig gewonnen, so daß die geschilderten Fehler beispielsweise bei einer Bewegung des Untersuchungsobjektes weitgehend vermieden werden.

Theoretisch kann man die Position der Mikrospule auch dann bestimmen, wenn die Gradientenrichtungen bei aufeinanderfolgenden Sequenzen nur wenig voneinander abweichen. In der Praxis ergeben sich jedoch dabei Fehler, die um so kleiner sind, je größer der Winkel zwischen den Gradientenrichtungen bei aufeinanderfolgenden Sequenzen ist; ein Minimum dieses Fehlers ergibt sich, wenn die zur Positionsbestimmung herangezogenen Gradientenrichtungen um 90° differieren.

Eine in diesem Sinne für die Positionsbestimmung in einem zweidimensionalen Bereich geeignete Weiterbildung der Erfindung sieht vor, daß die Gradientenrichtung von Sequenz zu Sequenz so variiert wird, daß zwei aufeinanderfolgende Sequenzen jeweils ein Paar bilden, dessen Gradientenrichtungen wesentlich voneinander abweichen, vorzugsweise um 90°.

Eine für die drei-dimensionale Lokalisierung der Mikrospule geeignete Ausgestaltung des Verfahrens sieht vor, daß die Gradientenrichtung von Sequenz zu Sequenz so variiert wird, daß drei aufeinanderfolgenden Sequenzen jeweils ein Tripel bilden, dessen Gradientenrichtungen wesentlich voneinander abweichen, vorzugsweise um 90°, wobei jede Gradientenrichtung außerhalb der durch die beiden anderen Gradientenrichtungen definierten Ebenen liegt.

Eine Anwendungsmöglichkeit des erfindungsgemäßen MR-Verfahrens besteht in der Detektion des Atmungszustandes mittels einer der Atmungsbewegung eines im Untersuchungs bereich befindlichen Patienten folgenden Mikrospule.

Ein MR-Gerät zur Durchführung des erfindungsgemäßen Verfahrens ist in Anspruch 5 angegeben.

Die Erfindung wird nachfolgend anhand der Zeichnung näher erläutert. Es zeigen:
- Fig. 1: ein MR-Gerät mit dem die Erfindung ausführbar ist,
- Fig. 2: den zeitlichen Verlauf verschiedener Signale bei zwei aufeinanderfolgenden Sequenzen,
- Fig. 3: die Lage der Pfade, längs derer die MR-Signale im k-Raum erfaßt werden,
- Fig. 4: die Bestimmung der Lage einer Mikrospule aus den bei zwei aufeinanderfolgenden Messungen gewonnenen Positionsdaten.

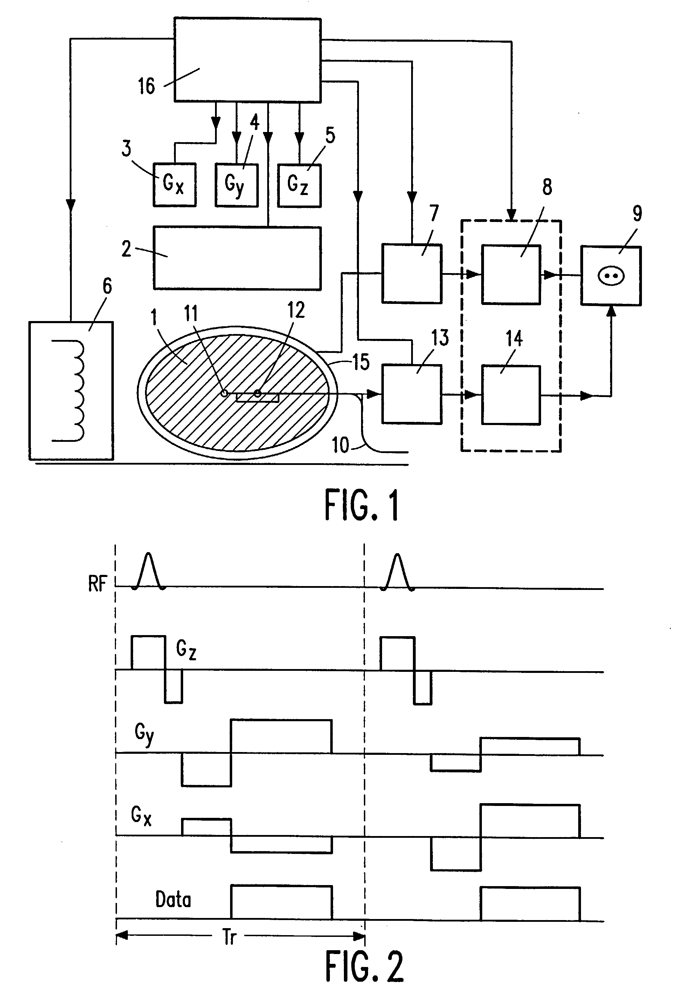

In Fig. 1 ist mit 1 ein Untersuchungsobjekt bezeichnet, das sich in einem Untersuchungsbereich befindet, der einem homogenen stationären Magnetfeld ausgesetzt ist, das von einem Hauptfeldmagneten 2 erzeugt wird. Das stationäre homogene Magnetfeld kann mittels dreier Gradientenanordnungen 3, 4 und 5 modifiziert werden, die ein magnetisches Gradientenfeld erzeugen, das ebenfalls in Richtung des homogenen stationären Magnetfeldes verläuft, das jedoch in x-, y- oder z-Richtung einen Gradienten aufweist. Weiterhin ist ein Hochfrequenzsender 6 vorgesehen, der im Untersuchungsbereich impulsweise ein hochfrequentes Magnetfeld erzeugen kann.

Die im Untersuchungsobjekt erzeugten MR-Signale werden von einer Empfangsspulen-Anordnung 15 (die aus einer oder mehreren Empfangsspulen bestehen kann) in Verbindung mit einer Empfängeranordnung 7 detektiert (die einen oder mehrere Empfangskanäle aufweisen kann). Aus den digitalisierten MR-Signalen wird nach einer Fourier-Transformation in einer Rekonstruktionseinheit 8 die Kernmagnetisierungsverteilung im Untersuchungsbereich rekonstruiert und in Form eines MR-Bildes auf einer Wiedergabeeinheit 9 wiedergegeben.

In das Untersuchungsobjekt 1 ist ein chirurgisches Instrument eingeführt, beispielsweise ein Katheter 10, an dessen Spitze - und ggf. noch an einer weiteren Stelle - eine Mikrospule 11 bzw. 12 befestigt ist. Die Mikrospulen 11 bzw. 12 können den in Fig. 2a bzw. 2b der US-PS 5 318 025 beschriebenen Aufbau haben. Die von den Mikrospulen 11, 12 gelieferten Signale werden einer (erforderlichenfalls - d.h. wenn mehrere, nicht in Serie geschaltete Mikrospulen benutzt werden -) mehrkanaligen Empfängeranordnung 13 und nach einer Fourier-Transformation einer Auswerteeinheit 14 zugeführt, die die Maxima ermittelt und aus zwei aufeinanderfolgenden Sequenzen die Position der Mikrospule(n) ermittelt und in das auf der Wiedergabeeinheit 9 dargestellte MR-Bild einblendet. Wie gestrichelt angedeutet, können die Komponenten 8 und 14 mittels eines geeignet programmierten Rechners realisiert werden. Die Komponenten 2 bis 15 werden durch eine programmierbare Steuereinheit 16 gesteuert.

Wie aus Fig. 2 ersichtlich, folgen die Sequenzen in dem durch die gestrichelten Linien angedeuteten zeitlichen Abstand Tᵣ aufeinander. In jeder Sequenz wird ein Hochfrequenzimpuls erzeugt (1. Zeile), der von einem Schichtselektionsgradienten begleitet wird, z.B. dem von der Gradientenanordnung 5 erzeugten Gradienten Gz (2. Zeile). Nach dem Hochfrequenzimpuls werden die beiden zum Schichtselektionsgradienten senkrechten Gradienten Gy und Gx eingeschaltet (3. bzw. 4. Zeile von Fig. 2), wobei die Polarität des Gradienten nach einer vorbestimmten Zeitspanne wechselt. Nach dem Wechsel wird das MR-Signal abgetastet, solange die Gradientenfelder Gx, Gy wirksam sind. Diese Gradientenfelder werden im folgenden auch als "Lesegradienten" bezeichnet. Bei dem dargestellten zeitlichen Verlauf dieser Gradientenfelder bedeutet das, daß bei der Erfassung des MR-Signals der k-Raum längs einer Geraden abgetastet wird, die durch den Nullpunkt des k-Raums verläuft und zu dem Nullpunkt symmetrisch ist.

Bei der nächsten Sequenz haben der Hochfrequenzimpuls (1. Zeile), der Schichtselektionsgradient (2. Zeile) und das Abtastintervall (5. Zeile) den gleichen zeitlichen Verlauf bzw. die gleiche zeitliche Lage innerhalb der Sequenz, jedoch sind die Lesegradienten Gx, Gy (3. und 4. Zeile) so geändert, daß ihr Betrag die gleiche Größe hat, wie in der vorangegangenen Sequenz, daß ihre Gradientenrichtung jedoch um 90° geändert ist. Die beiden in Fig. 2 dargestellten Sequenzen bilden also ein Paar, dessen Gradientenrichtungen miteinander einen Winkel von 90° bilden. Bei den darauffolgenden Sequenzen wird die Gradientenrichtung so variiert, daß jeweils zwei aufeinanderfolgende Sequenzen ein Paar mit um 90° versetzter Gradientenrichtung bilden, bis der k-Raum einmal vollständig abgetastet wird. Danach wiederholt sich die Sequenzenfolge solange, wie die Beobachtung des Katheters 10 erforderlich ist.

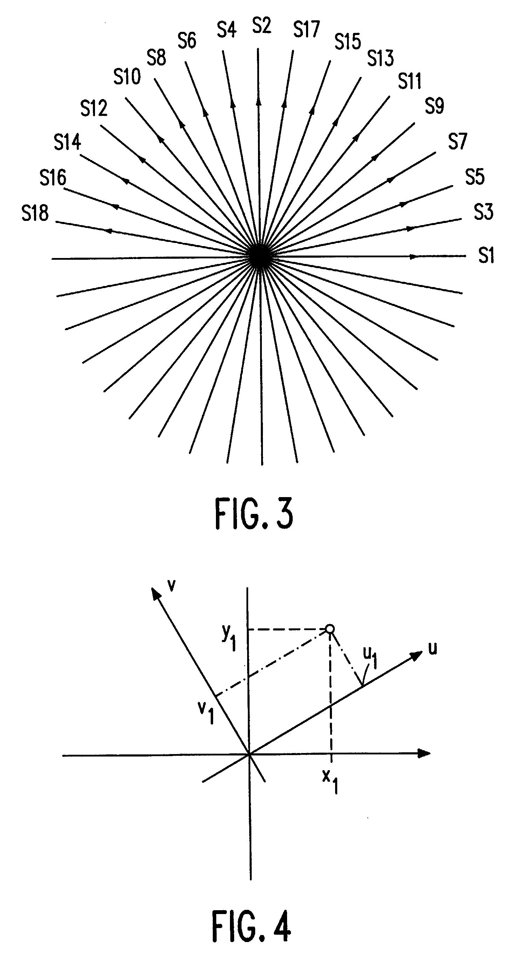

Fig. 3 zeigt die Pfade, längs derer der k-Raum bei den einzelnen Sequenzen abgetastet wird. Dabei steht S1 für die 1. Sequenz, S2 für die 2. Sequenz usw. Man erkennt, daß S1 und S2 ein Paar mit um 90° versetzter Gradientenrichtung bilden, ebenso S3 und S4 sowie S5 und S6 usw.

Da die MR-Signale unter der Einwirkung eines Lesegradienten (Gx, Gy) ausgelesen werden, ändert sich die Frequenz dieser Signale linear mit der Lage ihres Entstehungsortes in bezug auf die Gradientenrichtung. Da die Mikrospulen MR-Signale nur aus dem sie unmittelbar umgebenden Bereich aufnehmen können, während sie für MR-Signale aus weiter entfernt liegenden Bereichen praktisch unempfindlich sind, bedeutet dies, daß das in einer Mikrospule induzierte MR-Signal praktisch nur eine Frequenz aufweist, die von der Lage der Mikrospule abhängt. Diese Frequenz läßt sich aus dem Spektrum des MR-Signals (d.h. der Fouriertransformierten des MR-Signals) bestimmen, als diejenige Stelle an der das Spektrum seinen Maximalwert hat. Somit kann aus der Frequenzanalyse des MR-Signals die Position der Mikrospule in Gradientenrichtung bestimmt werden. Dies ist im einzelnen in der US-PS 5 318 025 beschrieben, worauf ausdrücklich Bezug genommen wird.

Fig. 4 erläutert die genaue Lokalisierung der Mikrospule. Dabei ist mit x und y ein feststehendes Koordinatensystem bezeichnet, innerhalb dessen die Kernmagnetisierungsverteilung bestimmt wird und mit u und v die Gradientenrichtungen von zwei aufeinanderfolgenden Sequenzen z. B. den Sequenzen S5 und S6. u₁ sei dabei die bei der 5. Sequenz in Gradientenrichtung ermittelte Position der Mikrospule, während v₁ die bei der 6. Sequenz ermittelte Position darstellen möge. Dann ergibt sich die Lage M der Mikrospule aus dem Schnittpunkt der die Achsen u und v in den Punkten u1 und v1 schneidenden senkrechten Geraden. Da bei den einzelnen Sequenzen die Gradientenrichtungen u und v vorbekannt sind, läßt sich daraus die Position x₁, y₁ in dem feststehenden x,y-Koordinatensystem ermitteln. Diese Position kann in das MR-Bild auf der Wiedergabeeinheit 9 eingeblendet werden.

Grundsätzlich ist es nicht erforderlich, daß die Gradientenrichtungen der jeweils ein Paar bildenden Sequenzen senkrecht zueinander stehen; theoretisch läßt sich die Position der Mikrospule auch dann ermitteln, wenn sich die Gradientenrichtungen u und v nur um einen kleinen Winkel unterscheiden, jedoch ist die Ungenauigkeit bei der Positionsbestimmung um so größer, je mehr der Winkel zwischen den Gradientenrichtungen von 90° abweicht. Deshalb sollte der Winkel zwischen den Gradientenrichtungen größer als 30° sein, insbesondere größer als 60° und vorzugsweise 90° betragen.

Zur Erzeugung eines MR-Bildes der Kernmagnetisierungsverteilung aus den MR-Signalen der Empfangspulen-Anordnung sind im allgemeinen N MR-Signale erforderlich, wobei N wesentlich größer ist als aus Fig. 3 ersichtlich und z.B. 128 beträgt. Der Zeitraum der für ein vollständig neues MR-Bild der Kernmagnetisierungsverteilung erforderlich ist, beträgt also NTᵣ. Bei der Rekonstruktion der Kernmagnetisierungsverteilung wird jedoch das MR-Bild fortlaufend durch die neu hinzugekommenen Projektionen (eine Projektion ist die Fouriertransformierte eines MR-Signals) ergänzt, indem die Differenz zwischen dieser Projektion und der - N Sequenzen zuvor - für die gleiche Gradientenrichtung ermittelte Projektion gebildet und daraus eine aktualisierte Kernmagnetisierungsverteilung bestimmt wird. Von Vorteil ist dabei, daß jede Projektion für den gesamten Untersuchungsbereich sowohl hochfrequente als auch niederfrequente Informationsanteile enthält.

Obwohl es also relativ lange dauert, bis sich das MR-Bild der Kernmagnetisierungsverteilung ändert, kann die Position der Mikrospule nach jedem Sequenzenpaar neu berechnet und in das MR-Bild eingeblendet werden. Die Aktualisierung der Position der MR-Spule erfolgt also wesentlich schneller als die Aktualisierung der MR-Bilder, nämlich jeweils nach dem Zeitraum 2Tᵣ.

Wenn die Aktualisierung der Mikrospulenposition noch schneller erfolgen soll, können bei geeigneter Abfolge der Gradientenrichtungen auch Sequenzen herangezogen werden, die nicht ein Paar bilden. Demgemäß würde die 1. Positionsbestimmung auf Basis der Sequenzen S1 und S2 erfolgen, während die nächste Positionsbestimmung nicht erst auf der Basis des nächsten Paares (S3-S4) erfolgen würde, sondern schon auf der Basis von S2 und S3. Dann sind die für die Berechnung der neuen Mikrospulenposition erforderlichen Signale schon jeweils nach dem Zeitraum Tᵣ akquiriert. Allerdings ist der Winkel zwischen S2 und S3 nicht genau 90°, sondern etwas kleiner; gleichwohl ist auch hierbei eine zuverlässige Bestimmung der Mikrospulenposition noch möglich, wie vorstehend erläutert wurde.

Die anhand der Figuren 2 bis 4 erläuterte Sequenz erlaubt lediglich die Bestimmung der Mikrospulenposition innerhalb einer durch den schichtselektiven Hochfrequenzimpuls einer jeden Sequenz bestimmten Schicht, d.h. in einem zwei-dimensionalen Bereich. Es ist jedoch auch möglich, die Sequenz so zu ändern, daß die Kernmagnetisierungsverteilung und die Mikrospulenposition dreidimensional ermittelt wird. Zu diesem Zweck darf der Gradient Gz nicht während des Hochfrequenzimpulses wirksam sein, sondern er muß während des Auslesens des MR-Signals auf den Untersuchungsbereich einwirken - wie auch die Gradienten Gy und Gx. Während bei der zweidimensionalen Methode die Pfade, längs derer die MR-Signale im k-Raum abgetastet werden, den Umfang eines Kreises definieren (vgl. Fig. 3) müssen bei einer dreidimensionalen Methode die Endpunkte der Pfade die Oberfläche einer Kugel definieren. Dabei müssen die Gradientenrichtungen so variiert werden, daß jeweils drei aufeinanderfolgende Sequenzen ein Tripel bilden. Innerhalb dieses Tripels sollte jede Gradientenrichtung mit den beiden anderen Gradientenrichtungen - sowie mit der durch diese Gradientenrichtungen definierten Ebene - einen genügend großen Winkel bilden, d.h. einen Winkel, der größer ist als 30°, vorzugsweise größer als 60°, und der insbesondere 90° beträgt.

Vorstehend wurde eine (oder mehrere) Mikrospulen dazu benutzt, die Position eines chirurgischen Instruments, z.B. eines Katheters im Körper des Untersuchungsobjektes 1 zu bestimmen. Es ist aber auch möglich, beispielsweise bei Bewegungsstudien eines (Knie-) Gelenks Mikrospulen, z.B. auf dem Ober- und dem Unterschenkel anzubringen und die daraus resultierende Lageinformation bei der Auswertung des MR-Bildes einzusetzen.

Eine weitere Anwendungsmöglichkeit des erfindungsgemäßen Verfahren besteht in der Bestimmung des zum Zeitpunkt der Akquisition der für ein MR-Bild erforderlichen MR-Signale bestehenden Atmungszustandes. Dazu wird eine Mikrospule an der Brust eines Patienten angebracht. Die Mikrospule folgt der Atembewegung, so daß aus ihrer Position der Atmungszustand ermittelt und mit dem MR-Bild visualisiert werden kann.

## Patentansprüche

1. Magnetresonanz-Verfahren zur Bestimmung der KernmagnetisierungsVerteilung in einem Untersuchungsbereich und zur Bestimmung der Position wenigstens einer Mikrospule (11,12), die sich in oder an einem im Untersuchungsbereich befindlichen Untersuchungsobjekt (1) befindet, wobei
a) ein homogenes stationäres Magnetfeld auf den Untersuchungsbereich einwirkt,
b) wenigstens ein auf den Untersuchungsbereich einwirkender Hochfrequenzimpuls erzeugt wird,
c) unter dem Einfluß eines auf den Untersuchungsbereich einwirkenden magnetischen Gradientenfeldes nach dem Hochfrequenzimpuls ein in der Mikrospule induziertes MR-Signal detektiert wird,
d) aus dem detektierten MR-Signal die Position der Mikrospule in der durch das Gradientenfeld definierten Gradientenrichtung ermittelt wird,
e) die Schritte b) bis d) bei einer anderen Gradientenrichtung wiederholt werden und
f) mit einer weiteren Empfangsspulen-Anordnung MR-Signale zur Bestimmung der Kernmagnetisierungsverteilung detektiert werden
dadurch gekennzeichnet, daß die Schritte b ) und c) fortlaufend unter Variation der Gradientenrichtung wiederholt werden und daß die Position der Mikrospule (11,12) und die Kernmagnetisierungsverteilung aus gleichzeitig von der Mikrospule und von der weiteren Empfangsspulen-Anordnung (15) detektierten MR-Signalen bestimmt werden, wobei während des Empfangs der zu einem Bild der Kernmagnetisierungsverteilung gehörenden MR-Signale durch die weitere Empfangsspulen-Anordnung (15) die aus aufeinanderfolgenden MR-Signalen in der Mikro-Spule berechnete Position fortlaufend aktualisiert wird.

2. MR-Verfahren nach Anspruch 1,
dadurch gekennzeichnet, daß die Gradientenrichtung von Sequenz zu Sequenz so variiert wird, daß zwei aufeinanderfolgende Sequenzen (z.B. S₁, S₂) jeweils ein Paar bilden, dessen Gradientenrichtungen wesentlich voneinander abweichen, vorzugsweise um 90°.

3. MR-Verfahren nach Anspruch 1,
dadurch gekennzeichnet, daß die Gradientenrichtung von Sequenz zu Sequenz so variiert wird, daß drei aufeinanderfolgende Sequenzen jeweils ein Tripel bilden, dessen Gradientenrichtungen wesentlich voneinander abweichen, vorzugsweise um 90°, wobei jede Gradientenrichtung außerhalb der durch die beiden anderen Gradientenrichtungen definierten Ebene liegt.

4. Anwendung des MR-Verfahrens nach Anspruch 1 zur Detektion des Atmungszustandes mittels einer der Atmungsbewegung eines im Untersuchungsbereich befindlichen Patienten folgenden Mikrospule.

5. Magnetresonanz-Gerät mit
a) Mitteln (2) zum Erzeugen eines homogenen, stationären Magnetfeldes in einem Untersuchungsbereich,
b) Mitteln (6) zum Erzeugen von auf den Untersuchungsbereich einwirkenden Hochfrequenzimpulsen,
c) Mitteln (3,4,5) zum Erzeugen von auf den Untersuchungsbereich einwirkenden magnetischen Gradientenfeldern mit steuerbarer Gradientenrichtung,
d) wenigstens einer Mikrospule (11,12) zur Detektion von MR-Signalen in Verbindung mit einem ersten Empfänger (13) mit einer der Zahl der Mikrospulen entsprechenden Anzahl von Empfangskanälen,
e) einer weiteren Empfangsspulen-Anordnung (15) zur Detektion von MR-Signalen in Verbindung mit einem zweiten Empfänger (7),
f) Mitteln (14) zum Bestimmen der Position der Mikrospule aus den vom ersten Empfänger (13) aufgenommenen MR-Signalen,
g) Mitteln (8) zum Bestimmen der Kernmagnetisierungsverteilung aus den vom zweiten Empfänger (7) aufgenommenen MR-Signalen,
h) einer Steuereinheit zur Steuerung der Komponenten des MR-Gerätes,
dadurch gekennzeichnet, daß zur Durchführung des Verfahrens nach Anspruch 1 die Steuereinheit (16) den ersten (13) und den zweiten Empfänger (7) und die Mittel (3,4,5) zum Erzeugen der magnetischen Gradientenfelder sowie die Mittel (8,14) zum Bestimmen der Position der Mikrospule und der Kermagnetisierungsverteilung derart steuert, daß die Gradientenrichtung fortlaufend variiert wird, und daß die Position der Mikrospule (11,12) und die Kernmagnetisierungsverteilung aus gleichzeitig von den Empfängern (7,13) aufgenommenen MR-Signalen bestimmt werden, wobei während des Empfangs der zu einem Bild der Kernmagnetisierungsverteilung gehörenden MR-Signale durch die weitere Empfangsspulen-Anordnung (15) die aus aufeinanderfolgenden MR-Signalen in der Mikrospule berechnete Position fortlaufend aktualisiert wird.

## Claims

1. A magnetic resistance method for determining the nuclear magnetic distribution in an examination area and for determining the position of at least one microcoil (11, 12) which is located in the examination area in or on an examination object (1), in which
a) a homogeneous stationary magnetic field acts on the examination area,
b) at least one high-frequency pulse acting on the examination area is generated,
c) after the high-frequency pulse a MR signal induced in the microcoil is detected under the influence of a gradient magnetic field that acts on the examination area,
d) the position of the microcoil in the gradient direction defined by the gradient field is derived from the detected MR signal,
e) the steps and b) to d) are repeated for another gradient direction, and
f) MR signals are detected by a further receiving coil arrangement for determining the nuclear magnetic distribution,
characterized in that the steps b) and c) are continuously repeated while the gradient direction is varied and in that the position of the microcoil (11, 12) and the nuclear magnetic distribution are derived from MR signals simultaneously detected by the microcoil and the further receiver coil arrangement (15), while during the reception of the MR signal belonging to an image of the nuclear magnetic distribution the position computed from consecutive MR signals is continuously updated by the further receiver coil arrangement (15).

2. A MR method as claimed in Claim 1, characterized in that the gradient direction is varied from one sequence to the next in such a way that two consecutive sequences (for example, S₁, S₂) form a pair whose gradient directions differ considerably, preferably by 90°.

3. A MR method as claimed in Claim 1, characterized in that the gradient direction is varied from one sequence to the next in such a way that three consecutive sequences form a triplet whose gradient directions differ considerably, preferably by 90°, while each gradient direction lies outside the planes defined by the other two gradient directions.

4. An implementation of the MR method as claimed in Claim 1, for detecting the respiratory condition via a microcoil that follows the respiratory movement of a patient positioned in the examination area.

5. A magnetic resistance device comprising:
a) means (2) for generating a homogeneous, stationary magnetic field in an examination area,
b) means (6) for generating high-frequency pulses that act on the examination area,
c) means (3, 4, 5) for generating gradient magnetic fields that act on the examination area which fields have a controllable gradient direction,
d) at least one microcoil (11, 12) for detecting MR signals, which is connected to a first receiver (13) that has a number of receiving channels corresponding to the number of microcoils,
e) a further receiver coil arrangement (15) for detecting MR signals, which is connected to a second receiver (7),
f) means for deriving the position of the microcoil from the MR signals detected by the first receiver (13),
g) means (8) for deriving the nuclear magnetic distribution from the MR signals detected by the second receiver (7),
h) a control unit for controlling the further components of the MR device,
characterized in that for carrying out the method as claimed in claim 1 the control unit (16) controls the first and second receivers (7, 13) and the means (3, 4, 5) for generating the gradient magnetic fields and the means (8, 14) for detecting the position of the microcoil and of the nuclear magnetic distribution in such a way that the gradient direction is continuously varied, and in that the position of the microcoil (11, 12) and the nuclear magnetic distribution are derived from MR signals simultaneously detected by the receivers (7, 13), while during the reception of the MR signal belonging to an image of the nuclear magnetic distribution the position computed from consecutive MR signals is continuously updated by the further receiver coil arrangement (15).

## Revendications

1. Procédé de résonance magnétique en vue de déterminer la distribution de la magnétisation nucléaire dans une zone d'examen et en vue de déterminer la position d'au moins une microbobine (11,12) qui se trouve dans ou sur un objet d'examen (1) situé dans la zone d'examen, auquel cas
a) un champ magnétique stationnaire homogène agit sur la zone d'examen,
b) au moins une impulsion à haute fréquence agissant sur la zone d'examen est produite,
c) sous l'influence d'un champ à gradient magnétique agissant sur la zone d'examen après l'impulsion à haute fréquence, un signal MR induit dans la microbobine est détecté,
d) à partir du signal MR détecté, la position de la microbobine est déterminée dans la direction de gradient définie par le champ de gradient,
e) les étapes b) à d) sont répétées pour une autre direction de gradient et
f) avec un dispositif supplémentaire à bobines réceptrices, des signaux MR sont détectés en vue de la détermination de la distribution de la magnétisation nucléaire,
caractérisé en ce que les étapes b) et c) sont répétées en permanence avec le changement de direction de gradient et que la position de la microbobine (11, 12) et la distribution de la magnétisation nucléaire sont déterminées à partir de signaux MR détectés simultanément par la microbobine et par le dispositif supplémentaire (15) de bobines de réception, la position calculée à partir des signaux MR successifs dans la microbobine étant actualisée en permanence pendant la réception des signaux MR faisant partie d'une image de la distribution de la magnétisation nucléaire par le dispositif supplémentaire de bobines de réception (15).

2. Procédé MR selon la revendication 1, caractérisé en ce que la direction de gradient varie d'une séquence à l'autre de telle sorte que deux séquences successives (par exemple S1, S2) forment respectivement une paire dont les directions des gradients diffèrent essentiellement l'une de l'autre, de préférence de 90°.

3. Procédé MR selon la revendication 1, caractérisé en ce que la direction de gradient varie d'une séquence à l'autre de telle sorte que trois séquences successives forment respectivement un triplet dont les directions de gradient diffèrent essentiellement l'une de l'autre, de préférence de 90°, chaque direction de gradient se trouvant en dehors du plan défini par les deux autres directions de gradient.

4. Utilisation du procédé MR selon la revendication 1 pour la détection de l'état de respiration à l'aide d'une microbobine suivant le mouvement respiratoire d'un patient situé dans la zone d'examen.

5. Appareil à résonance magnétique avec
a) des moyens (2) de production d'un champ magnétique stationnaire homogène dans une zone d'examen,
b) des moyens (6) de production d'impulsions à haute fréquence agissant sur la zone d'examen,
c) des moyens (3, 4, 5) de production de champs à gradient magnétiques agissant sur la zone d'examen avec une direction de gradient susceptible d'être commandée,
d) au moins une microbobine (11, 12) en vue de la détection de signaux MR associés à un premier récepteur (13) avec un nombre de canaux de réception correspondant au nombre des microbobines,
e) un dispositif supplémentaire de bobines de réception (15) en vue de la détection de signaux MR associés à un deuxième récepteur (7),
f) des moyens (14) en vue de déterminer la position de la microbobine à partir des signaux MR enregistrés par le premier récepteur (13),
g) des moyens (8) en vue de déterminer la distribution de la magnétisation nucléaire à partir des signaux MR enregistrés par le deuxième récepteur (7),
h) une unité de commande en vue de la commande des composants de l'appareil MR,
caractérisé en ce qu'en vue de l'exécution du procédé selon la revendication 1, l'unité de commande (16) commande les premier (13) et deuxième (7) récepteurs et les moyens (3, 4, 5) en vue de la production des champs à gradient magnétiques ainsi que les moyens (8, 14) en vue de la détermination de la position de la microbobine et de la distribution de la magnétisation nucléaire de telle sorte que la direction de gradient varie en continu et que la position de la microbobine (11, 12) et la distribution de la magnétisation nucléaire soient déterminées à partir de signaux MR enregistrés simultanément par les récepteurs (7, 13), la position calculée à partir des signaux MR successifs dans la microbobine étant actualisée en permanence pendant la réception des signaux MR appartenant à une image de la distribution de la magnétisation nucléaire par le dispositif supplémentaire de bobines de réception. (15).
